# EUROPEAN PATENT APPLICATION

(11) **EP 1 930 907 A2**
(43) Date of publication of application: **11.06.2008**
(21) Application number: 07023602.1
(22) Date of filing: 05.12.2007
(51) Int. Cl.: G11C 11/16

(54) **Spin glass memory cell**

(30) Priority: 07.12.2006 US 635163
(71) Applicant: Qimonda North America Corp., Cary, NC 27513 (US)
(72) Inventor: Philipp, Jan Boris, 81673 München (DE)
(74) Representative: Jehle, Volker Armin

(57) **Abstract**

A memory cell includes a first electrode, a second electrode, and spin glass material. The spin glass material is coupled between the first electrode and the second electrode.
The spin glass material can be brought into a described state by heating, whereby the resistance of the material is raised.
The spin glass material can then be programmed by either applying a magnetic field to the device or by applying a current to a spin torque injector.
Thereby, gradual resistance changes can be reached, providing either single exit or multiexit storage devices.

## Description

### Background

One type of memory is resistive memory. Resistive memory utilizes the resistance value of a memory element to store one or more bits of data. For example, a memory element programmed to have a high resistance value may represent a logic "1" data bit value, and a memory element programmed to have a low resistance value may represent a logic "0" data bit value. The resistance value of the memory element is switched electrically by applying a voltage pulse or a current pulse to the memory element. Two types of resistive memory are phase change random access memory (PCRAM) and magnetic random access memory (MRAM).

PCRAM devices include an array of phase change memory cells. Phase change memories are based on phase change materials that exhibit at least two different states. Phase change material may be used in memory cells to store bits of data. The states of phase change material may be referred to as amorphous and crystalline states. The states may be distinguished because the amorphous state generally exhibits higher resistivity than does the crystalline state. Generally, the amorphous state involves a more disordered atomic structure, while the crystalline state involves a more ordered lattice.

Phase change in the phase change materials may be induced reversibly. In this way, the memory may change from the amorphous state to the crystalline state and from the crystalline state to the amorphous state in response to temperature changes. The temperature changes to the phase change material may be achieved in a variety of ways. For example, a laser can be directed to the phase change material, current may be driven through the phase change material, or current can be fed through a resistive heater adjacent the phase change material. In any of these methods, controllable heating of the phase change material causes controllable phase change within the phase change material.

MRAM devices include an array of magnetic memory cells. The magnetic memory cells may be of different types, such as a magnetic tunnel junction (MTJ) memory cell or a giant magnetoresistive (GMR) memory cell. A magnetic memory cell typically includes a layer of magnetic film in which the orientation of magnetization is alterable and a layer of magnetic film in which the orientation of magnetization is fixed or "pinned" in a particular direction. The magnetic film having alterable magnetization is referred to as a sense layer or data storage layer, and the magnetic film that is fixed is referred to as a reference layer or pinned layer. In an MTJ memory cell, a barrier layer separates the sense layer and the reference layer.

A magnetic memory cell stores a bit of information as an orientation of magnetization in the sense layer. The orientation of magnetization in the sense layer aligns along an axis of the sense layer referred to as its easy axis. The orientation of magnetization does not easily align along an axis orthogonal to the easy axis, referred to as the hard axis. Magnetic fields are applied to flip the orientation of magnetization in the sense layer along its easy axis to either a parallel or anti-parallel orientation with respect to the orientation of magnetization in the reference layer.

The resistance through a magnetic memory cell differs according to the parallel or anti-parallel orientation of magnetization of the sense layer and the reference layer. The resistance is highest when the orientation is anti-parallel, and lowest when the orientation is parallel. The resistive state of the memory cell can be determined by sensing the resistance through the memory cell.

For data storage applications, reducing the power requirements for programming memory cells is a continuing goal. By reducing the power requirements of memory cells, the size and cost of circuitry used to program the memory cells and the cost of operating the memory may be reduced.

For these and other reasons, there is a need for the present invention.

### Summary

One embodiment of the present invention provides a memory cell. The memory cell includes a first electrode, a second electrode, and spin glass material. The spin glass material is coupled between the first electrode and the second electrode.

### Brief Description of the Drawings

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
Figure 1 is a block diagram illustrating one embodiment of a memory device.
Figure 2 illustrates a cross-sectional view of one embodiment of a spin glass memory cell.
Figure 3 illustrates a cross-sectional view of another embodiment of a spin glass memory cell.
Figure 4 is a graph illustrating one embodiment of writing a spin glass memory cell to an ordered state.
Figure 5 is a graph illustrating another embodiment of writing a spin glass memory cell to an ordered state.

### Detailed Description

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

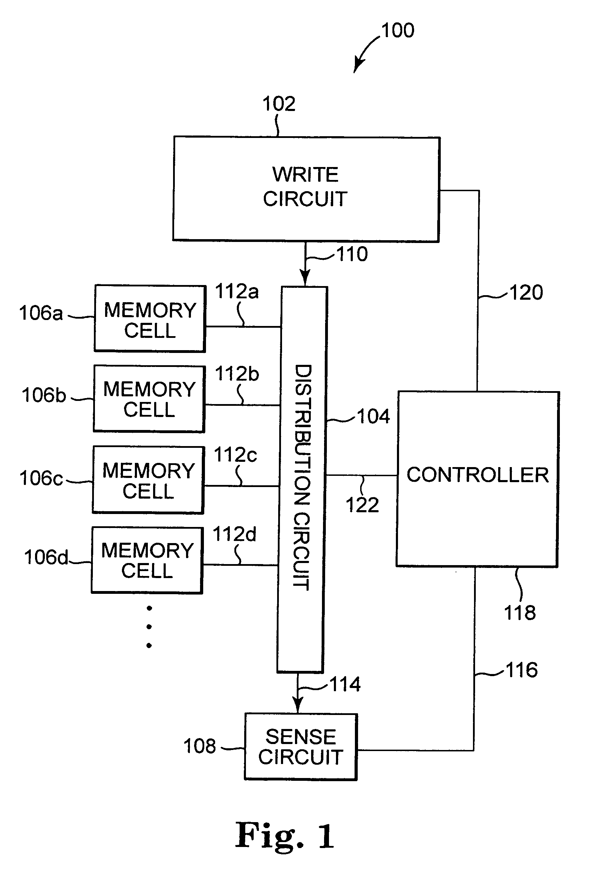

Figure 1 is a block diagram illustrating one embodiment of a memory device 100. Memory device 100 includes a write circuit 102, a distribution circuit 104, memory cells 106a, 106b, 106c, and 106d, a sense circuit 108, and a controller 118. Each of the memory cells 106a-106d is a spin glass memory cell that stores data based on the disordered and ordered states of spin glass material in each memory cell. Also, each of the memory cells 106a-106d can be programmed into two or more states by programming the spin glass material to have intermediate resistance values. To program one of the memory cells 106a-106d to an intermediate resistance value, the degree of spin order - and hence the cell resistance - is controlled via a suitable write strategy.

Memory device 100 is configured to program memory cells 106a-106d to an ordered state or a disordered state. In one embodiment, to write a memory cell 106a-106d to a disordered state, the spin glass material is heated above the spin glass temperature of the spin glass material. The spin glass temperature of the spin glass material is the temperature at which the spin glass material transitions to the disordered state. In other embodiments, a memory cell 106a-106d is written to the disordered state using another suitable technique. In one embodiment, to write a memory cell 106a-106d to an ordered state, either a current is applied to a spin torque injector contacting the spin glass material to program the spin glass material to an ordered state, or a magnetic field is applied to the memory cell to program the spin glass material to the ordered state. In other embodiments, a memory cell 106a-106d is written to the ordered state using another suitable technique.

As used herein, the term "electrically coupled" is not meant to mean that the elements must be directly coupled together and intervening elements may be provided between the "electrically coupled" elements.

Write circuit 102 is electrically coupled to distribution circuit 104 through signal path 110. Distribution circuit 104 is electrically coupled to each of the memory cells 106a-106d through signal paths 112a-112d. Distribution circuit 104 is electrically coupled to memory cell 106a through signal path 112a. Distribution circuit 104 is electrically coupled to memory cell 106b through signal path 112b. Distribution circuit 104 is electrically coupled to memory cell 106c through signal path 112c. Distribution circuit 104 is electrically coupled to memory cell 106d through signal path 112d. Distribution circuit 104 is electrically coupled to sense circuit 108 through signal path 114. Sense circuit 108 is electrically coupled to controller 118 through signal path 116. Controller 118 is electrically coupled to write circuit 102 through signal path 120 and distribution circuit 104 through signal path 122.

One or more of the memory cells 106a-106d includes spin glass material. Spin glass material is magnetic material (typically an alloy) whose atomic magnets are involved in a mixture of ferromagnetic and antiferromagnetic interactions. The ferromagnetic and antiferromagnetic interactions cause frustration, such that not all the constraints necessary to minimize the system's overall energy can be simultaneously satisfied. Spin glass material can exhibit an exponential number of stable states.

Spin glass material may be changed from a disordered state to an ordered state or from an ordered state to a disordered state under the influence of spin torque injection, a magnetic field, and/or temperature change. The ordered and disordered spin structures of the spin glass material of one of the memory cells 106a-106d thereby defines two or more states for storing data within memory device 100. In the disordered state, a spin glass material exhibits significantly higher resistivity than in the ordered state. Therefore, the two or more states of memory cells 106a-106d differ in their electrical resistivity. In one embodiment, the two or more states can be three states and a trinary system can be used, wherein the three states are assigned bit values of "0", "1", and "2". In one embodiment, the two or more states are four states that can be assigned multi-bit values, such as "00", "01", "10", and "11". In other embodiments, the two or more states can be any suitable number of states in the spin glass material of a memory cell.

Controller 118 controls the operation of write circuit 102, sense circuit 108, and distribution circuit 104. Controller 118 includes a microprocessor, microcontroller, or other suitable logic circuitry for controlling the operation of write circuit 102, sense circuit 108, and distribution circuit 104. Controller 118 controls write circuit 102 for setting the resistance states of memory cells 106a-106d. Controller 118 controls sense circuit 108 for reading the resistance states of memory cells 106a-106d. Controller 118 controls distribution circuit 104 for selecting memory cells 106a-106d for read or write access.

Write circuit 102 provides signals to memory cells 106a-106d and programs one of the two or more resistance levels or states into the spin glass material of each of the memory cells 106a-106d. In one embodiment, write circuit 102 provides current or voltage signals to distribution circuit 104 through signal path 110 and distribution circuit 104 controllably directs the current or voltage signals to conductive lines, such as word lines and bit lines, to generate magnetic fields in memory cells 106a-106d. The magnetic fields program the memory cells 106a-106d to the ordered state. In one embodiment, distribution circuit 104 includes a plurality of transistors that controllably direct voltage signals to each of the memory cells 106a-106d for generating the magnetic fields. In other embodiments, write circuit 102 provides current signals to distribution circuit 104 through signal path 110 and distribution circuit 104 controllably directs the current signals to memory cells 106a-106d through signal paths 112a-112d. The current signals are applied to spin torque injectors adjacent the spin glass material to program memory cells 106a-106d to the ordered state or are applied directly to the spin glass material to heat the spin glass material to program memory cells 106a-106d to the disordered state.

Sense circuit 108 reads each of the two or more states of memory cells 106a-106d through signal path 114. Distribution circuit 104 controllably directs read signals between sense circuit 108 and memory cells 106a-106d through signal paths 112a-112d. In one embodiment, distribution circuit 104 includes a plurality of transistors that controllably direct read signals between sense circuit 108 and memory cells 106a-106d. In one embodiment, to read the resistance of one of the memory cells 106a-106d, sense circuit 108 provides current that flows through one of the memory cells 106a-106d and sense circuit 108 reads the voltage across that one of the memory cells 106a-106d. In one embodiment, sense circuit 108 provides voltage across one of the memory cells 106a-106d and reads the current that flows through that one of the memory cells 106a-106d. In one embodiment, write circuit 102 provides voltage across one of the memory cells 106a-106d and sense circuit 108 reads the current that flows through that one of the memory cells 106a-106d. In one embodiment, write circuit 102 provides current through one of the memory cells 106a-106d and sense circuit 108 reads the voltage across that one of the memory cells 106a-106d.

In operation of one embodiment, write circuit 102 resets the spin glass material in a target memory cell 106a-106d to a disordered state. A reset operation includes heating the spin glass material of the target memory cell above the spin glass temperature and cooling the spin glass material to thereby achieve the disordered state. This disordered state is one of the two or more states of each of the memory cells 106a-106d and is the highest resistance state.

From the disordered state, write circuit 102 programs a selected one of the two or more states into the target memory cell. Write circuit 102 provides a signal to the target memory cell to order the spin glass material and thereby lower the resistance of the target memory cell. The spin glass material is ordered by either applying a magnetic field to the spin glass material or by applying current to a spin torque injector contacting the spin glass material.

In operation of another embodiment, write circuit 102 sets the spin glass material in a target memory cell 106a-106d to an ordered state. A set operation includes either applying a magnetic field to the spin glass material or applying a current to a spin torque injector contacting the spin glass material to thereby achieve the ordered state. This ordered state is one of the two or more states of each of the memory cells 106a-106d and is the lowest resistance state.

From the ordered state, write circuit 102 programs a selected one of the two or more states into the target memory cell. Write circuit 102 provides a signal to the target memory cell to disorder the spin glass material and thereby raise the resistance of the target memory cell. The spin glass material is disordered by heating the spin glass material above the spin glass temperature of the spin glass material.

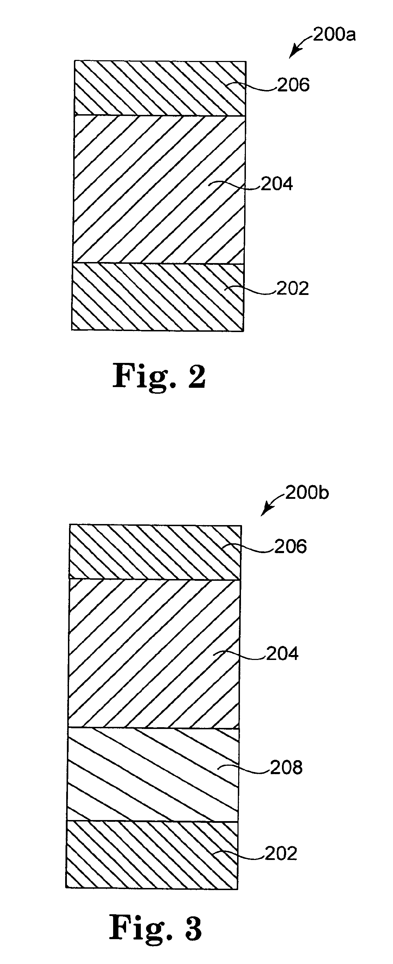

Figure 2 illustrates a cross-sectional view of one embodiment of a spin glass memory cell 200a. In one embodiment, memory cells 106a-106d are similar to memory cell 200a. Memory cell 200a includes a first electrode 202, spin glass material 204, and a second electrode 206. First electrode 202 contacts spin glass material 204. Spin glass material 204 contacts second electrode 206. First electrode 202, spin glass material 204, and second electrode 206 can be provided in any suitable configuration, such as a pillar type memory cell, a via type memory cell, or a planar or bridge type memory cell.

First electrode 202 and second electrode 206 include any suitable electrode material, such as TiN, TaN, W, WN, TiSiN, TiAIN, TaAlN, Cu, Al, Au, Ag, or Pt. Spin glass material 204 includes any suitable spin glass material that exhibits a change in resistivity between an ordered state and a disordered state.

During a write operation, to transition spin glass material 204 from a disordered state to an ordered state, write circuit 102 applies a magnetic field to the selected memory cell. In one embodiment, write circuit 102 selects two conductive lines coupled to the selected memory cell to order the spin glass material 204 of the selected memory cell. In one embodiment, the two conductive lines include a word line and a bit line. Write circuit 102 supplies write currents to the selected two conductive lines to create a magnetic field in the selected memory cell. These write currents may be the same or different in magnitude. The magnetic field transitions the spin glass material 204 in the selected memory cell from the disordered state to the ordered state.

To transition spin glass material 204 from an ordered state to a disordered state, write circuit 102 provides a current from first electrode 202 or second electrode 206 to the other of first electrode 202 or second electrode 206 through spin glass material 204. The current heats spin glass material 204 above the spin glass temperature. Once the spin glass temperature of spin glass material 204 is exceeded, the current is removed and spin glass material 204 cools into the disordered state.

Figure 3 illustrates a cross-sectional view of another embodiment of a spin glass memory cell 200b. In one embodiment, memory cells 106a-106d are similar to memory cell 200b. Memory cell 200b includes first electrode 202, spin torque injector 208, spin glass material 204, and second electrode 206. First electrode 202 contacts spin torque injector 208. Spin torque injector 208 contacts spin glass material 204. Spin glass material 204 contacts second electrode 206. First electrode 202, spin torque injector 208, spin glass material 204, and second electrode 206 can be provided in any suitable configuration, such as a pillar type memory cell, a via type memory cell, or a planar or bridge type memory cell.

First electrode 202 and second electrode 206 include any suitable electrode material, such as TiN, TaN, W, WN, TiSiN, TiAIN, TaAlN, Cu, Al, Au, Ag, or Pt. Spin torque injector 208 includes any suitable spin injector material, such as a magnetic transition metal, a magnetic transition metal alloy, a magnetic oxide such as CrO₂, or a magnetic semiconductor. Spin glass material 204 includes any suitable spin glass material that exhibits a change in resistivity between an ordered state and a disordered state.

During a write operation, to transition spin glass material 204 from a disordered state to an ordered state, write circuit 102 applies a current to first electrode 202 and spin torque injector 208 to inject spin torque into spin glass material 204 of the memory cell to transition spin glass material 204 to the ordered state.

To transition spin glass material 204 from an ordered state to a disordered state, write circuit 102 provides a current from first electrode 202 or second electrode 206 to the other of first electrode 202 or second electrode 206 through spin glass material 204. The current heats spin glass material 204 above the spin glass temperature. Once the spin glass temperature of spin glass material 204 is exceeded, the current is removed and spin glass material 204 cools into the disordered state.

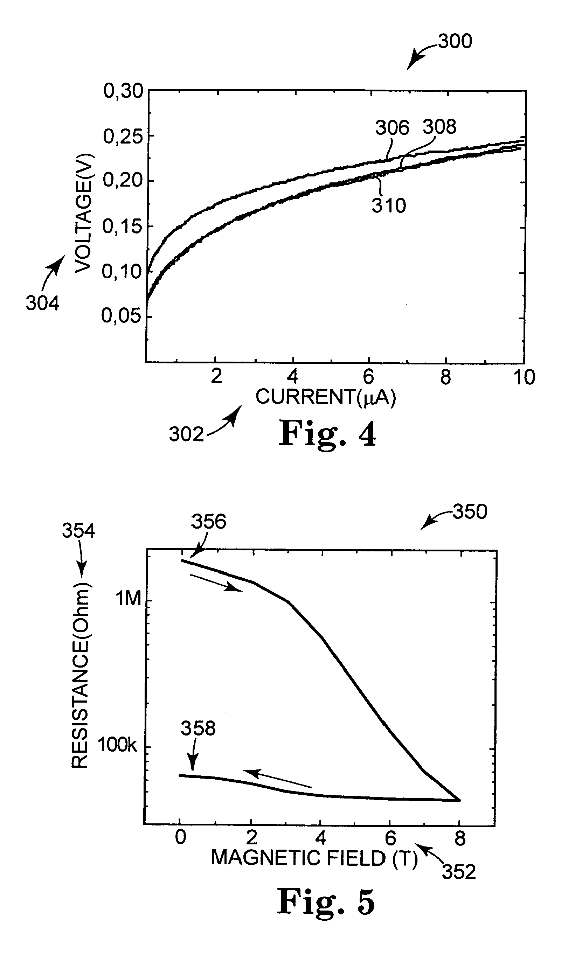

Figure 4 is a graph 300 illustrating one embodiment of writing a spin glass memory cell to an ordered state. Graph 300 includes current in micro amps (µA) on x-axis 302 and voltage in volts (V) on y-axis 304. Graph 300 illustrates current versus voltage for current flowing through a spin glass structure including a bottom La_{2/3}Ba_{1/3}MnO₆ layer having a thickness of 27nm, a middle La_{2/3}Ca_{1/3}MnO₆ layer having a thickness of 6nm, and a top La_{2/3}Ba_{1/3}MnO₆ layer having a thickness of 12nm. Each of the bottom layer, the middle layer, and the top layer has a length of 3µm and a width of 3µm. The values were obtained at a temperature of 5 Kelvin (K).

Curve 306 illustrates current versus voltage for a current sweep from 0µA to +10µA. Curve 308 illustrates current versus voltage for a current sweep from 10µA to -10µA. On decreasing the current, a lower voltage is provided at the same current values. Therefore, the applied current of 10µA has transitioned the spin glass material to a lower resistance state, which is the ordered state. Curve 310 illustrates current versus voltage for a current sweep from -10µA to +10µA. As indicated by curve 310, after the spin glass material has been transitioned to the ordered state, the resistance is stable and independent of the applied current. This ordered spin glass material state has a lower resistance than the disordered state.

Figure 5 is a graph 350 illustrating another embodiment of writing a spin glass memory cell to an ordered state. Graph 350 includes magnetic field in Tesla (T) on x-axis 352 and resistance in Ohms (Ω) on y-axis 354. Graph 350 illustrates magnetic field versus resistance for a spin glass structure of a 68nm La_{2/3}Ca_{1/3}MnO₆ layer on a SrTiO₃ substrate. As illustrated by graph 350, the disordered state as indicated at 356 has a higher resistance than the ordered state as indicated at 358. From the disordered state indicated at 356, a magnetic field is applied, which transitions the spin glass material to the ordered state. Once the spin glass material achieves the ordered state, the spin glass material remains stable as indicated at 358 if the magnetic field remains applied or if the magnetic field is removed. With the magnetic field removed, the spin glass material exhibits a lower resistivity in the ordered state than in the disordered state.

Embodiments of the present invention provide a spin glass memory cell. The spin glass memory cell has a smaller reset current for transitioning the spin glass memory cell to the disordered state compared to the reset current for transitioning a phase change memory cell to the amorphous state since the spin glass memory cell is only heated above the spin glass temperature. In addition, the spin glass memory cell has a smaller set current for transitioning the spin glass memory cell to the ordered state compared to the set current for transitioning a phase change memory cell to the crystalline state. The spin glass memory cell may utilize any suitable phase change memory or magnetic random access memory concepts, such as array layouts, memory cell structure, and addressing schemes.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A memory cell comprising:
a first electrode;
a second electrode; and
spin glass material coupled between the first electrode and the second electrode.

2. The memory of claim 1, further comprising:
a spin torque injector coupled between the spin glass material and the first electrode.

3. The memory of claim 1, wherein the spin glass material provides a first resistivity in an ordered state and provides a second resistivity in a disordered state, the second resistivity greater than the first resistivity.

4. The memory of claim 3, wherein the spin glass material transitions to the ordered state in response to a magnetic field.

5. The memory of claim 3, wherein the spin glass material transitions to the ordered state in response to spin torque injection.

6. The memory of claim 3, wherein the spin glass material transitions to the disordered state in response to heating the spin glass material above a spin glass temperature of the spin glass material.

7. A memory comprising:
a plurality of spin glass memory cells; and
a circuit for selectively writing each of the spin glass memory cells to an ordered state and a disordered state.

8. The memory of claim 7, wherein each memory cell comprises:
a first electrode;
a second electrode; and
spin glass material coupled between the first electrode and the second electrode.

9. The memory of claim 8, wherein each memory cell further comprises:
a spin torque injector coupled between the spin glass material and the first electrode.

10. The memory of claim 8, wherein the spin glass material of each memory cell provides a first resistivity in the ordered state and provides a second resistivity in the disordered state, the second resistivity greater than the first resistivity.

11. The memory of claim 10, wherein the spin glass material of each memory cell transitions to the ordered state in response to a magnetic field.

12. The memory of claim 10, wherein the spin glass material of each memory cell transitions to the ordered state in response to spin torque injection.

13. The memory of claim 10, wherein the spin glass material of each memory cell transitions to the disordered state in response to heating the spin glass material of each memory cell above a spin glass temperature of the spin glass material of each memory cell.

14. A memory comprising:
means for storing data based on ordered and disordered spin glass material states;
means for accessing the means for storing data; and
means for programming the means for storing data.

15. The memory of claim 14, wherein the means for programming comprises means for injecting spin torque into the means for storing.

16. The memory of claim 14, wherein the means for programming comprises means for generating magnetic fields in the means for storing.

17. A method for fabricating a memory cell, the method comprising:
providing a first electrode;
coupling spin glass material to the first electrode; and
coupling a second electrode to the spin glass material.

18. The method of claim 17, further comprising:
coupling a spin torque injector between the spin glass material and the first electrode.

19. The method of claim 17, wherein coupling the spin glass material comprises coupling spin glass material that provides a first resistivity in an ordered state and provides a second resistivity in a disordered state, the second resistivity greater than the first resistivity.

20. A method for programming a memory cell, the method comprising:
providing a spin glass memory cell;
selectively applying one of a first signal to the memory cell to program the memory cell to a disordered state and a second signal to the memory cell to program the memory cell to an ordered state.

21. The method of claim 20, wherein selectively applying the first signal comprises selectively applying a current through the memory cell to heat the memory cell above a spin glass temperature of the memory cell.

22. The method of claim 20, wherein selectively applying the second signal comprises selectively applying the second signal to generate a magnetic field in the memory cell.

23. The method of claim 20, wherein providing the spin glass memory cell comprises providing a spin glass memory cell including a spin torque injector, and wherein selectively applying the second signal comprises selectively applying a current signal to the spin torque injector.
